(19) Europäisches Patentamt
European Patent Office
Office européen des brevets

(11) **EP 1 794 602 B1**

(12) **EUROPÄISCHE PATENTSCHRIFT**

(45) Veröffentlichungstag und Bekanntmachung des Hinweises auf die Patenterteilung:
**12.10.2016   Patentblatt 2016/41**

(21) Anmeldenummer: **05785761.7**

(22) Anmeldetag: **26.08.2005**

(51) Int Cl.:
*G01R 23/18* (2006.01)      *G01R 23/167* (2006.01)

(86) Internationale Anmeldenummer:
**PCT/EP2005/009254**

(87) Internationale Veröffentlichungsnummer:
**WO 2006/034763 (06.04.2006 Gazette 2006/14)**

(54) **VERFAHREN UND VORRICHTUNG ZUR SPEKTRUMANALYSE EINES NUTZ- ODER RAUSCHSIGNALS**

METHOD AND DEVICE FOR PERFORMING SPECTRUM ANALYSIS OF A WANTED SIGNAL OR NOISE SIGNAL

PROCÉDÉ ET DISPOSITIF D'ANALYSE SPECTRALE D'UN SIGNAL UTILE OU D'UN SIGNAL DE BRUIT

(84) Benannte Vertragsstaaten:
**DE FR GB**

(30) Priorität: **28.09.2004   DE 102004047042**

(43) Veröffentlichungstag der Anmeldung:
**13.06.2007   Patentblatt 2007/24**

(73) Patentinhaber: **Rohde & Schwarz GmbH & Co. KG**
**81671 München (DE)**

(72) Erfinder:
• **FELDHAUS, Gregor**
  **81669 München (DE)**
• **ECKERT, Hagen**
  **86415 Mering (DE)**

(74) Vertreter: **Körfer, Thomas**
**Mitscherlich PartmbB**
**Patent- und Rechtsanwälte**
**Postfach 33 06 09**
**80066 München (DE)**

(56) Entgegenhaltungen:
DE-A1- 2 137 172     DE-A1- 4 011 577
DE-A1- 4 330 425     US-A- 5 748 507

**Beschreibung**

Die Erfindung betrifft ein Verfahren und eine Vorrichtung zur Spektrumanalyse eines Nutz- oder Rauschsignals.

Die Analyse eines Nutz- oder Rauschsignals mit einem Spektrumanalysator oder an einem Rauschmeßplatz erfordert eine Spektrumanalyse über einen weiten Frequenzbereich.

Die DE 21 37 172 A1 beschreibt einen Spektrumanalysator zur Fourieranalyse eines elektrischen Signals in einem einzigen Frequenzband.

In der DE 43 30 425 A1 wird das zu vermessende Signal in mehrere Teilsignale getrennt und für jedes Teilsignal jeweils ein Teilspektrum ermittelt. Das Gesamtspektrum des zu vermessenden Signals wird in der DE 43 30 425 A1 schließlich aus den Teilspektren zusammengesetzt. Zur effizienten Messung des Signal- oder Rauschspektrums wird der gesamte zu vermessende Frequenzbereich in mehrere Frequenzbänder unterteilt.

Während aus der US 5,748,507 A1 eine Spektralanalyse eines zu messenden Signals in mehreren Frequenzbändern mit jeweils identischer Frequenzauflösung hervorgeht, wird in der DE 40 11 577 A1 eine Spektralanalyse eines zu messenden Signals in mehreren Frequenzbändern mit jeweils unterschiedlicher Frequenzauflösung beschrieben.

Zur effizienten Messung des Signal- oder Rauschspektrums wird der gesamte zu vermessende Frequenzbereich in mehrere Frequenzbänder unterteilt, die jeweils mit unterschiedlicher Frequenzauflösung vermessen werden. Beispielsweise kann es sinnvoll sein, die Frequenzauflösung mit zunehmenden Frequenzabstand zum Meßsignal zu verringern. Dadurch werden tieferfrequente Frequenzbänder (Frequenzbänder mit geringem Frequenzoffset zum Meßsignal) mit einer höheren Frequenzauflösung als höherfrequente Frequenzbänder (Frequenzbänder mit großem Frequenzoffset zum Meßsignal) vermessen.

Typischerweise arbeiten moderne Spektrumsanalysatoren nach dem Überlagerungsprinzip. Für hohe Frequenzauflösungen wird das Zwischenfrequenzsignal abgetastet und einer FFT-Analyse unterworfen. Für geringe Frequenzauflösungen werden analoge Filter im ZF-Zwischenpfad verwendet und der Analysator in einem Sweep-Modus betrieben.

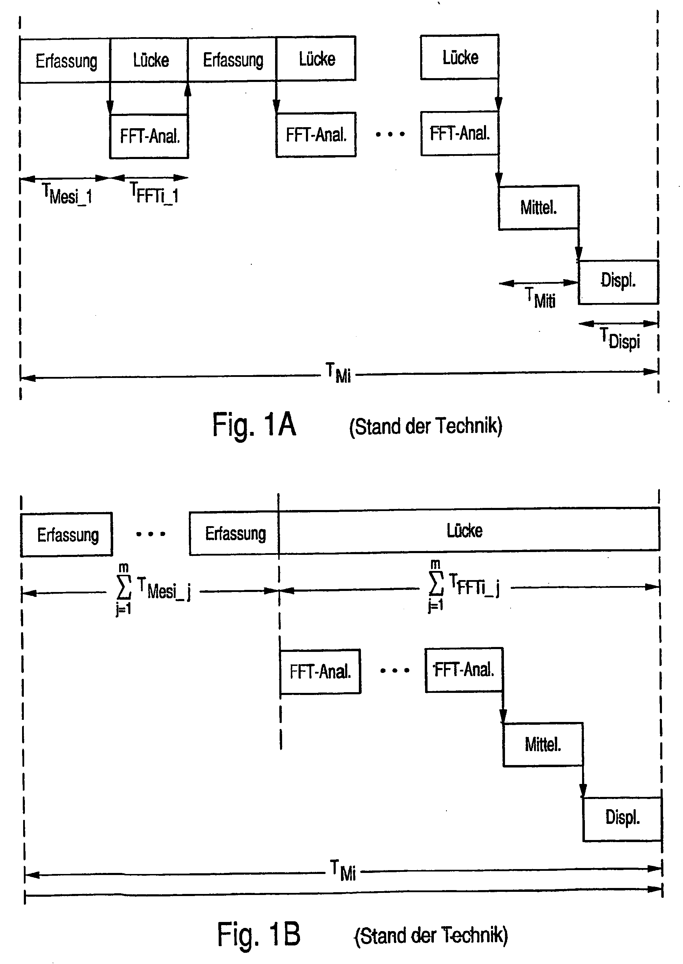

Bei einem nach der diskreten Fast-Fourier-Analyse (FFT-Analyse) arbeitenden Spektrumanalysator ergibt sich die Gesamtmeßzeit $T_{MGes}$ aus der Summe der Meßzeiten $T_{Mi}$ der einzelnen Frequenzbänder. Die Meßzeit $T_{Mi}$ je Frequenzband setzt sich gemäß Fig. 1A wiederum aus einem der Anzahl an Mittelungen entsprechenden Vielfachen der additiven Verknüpfung aus Datenerfassungszeit $T_{Mesi\_j}$ und Datenauswertungszeit $T_{FFTi\_j}$ für die Fourier-Analyse zzgl. einer Mittelungszeit $T_{Miti}$ und Darstellungszeit $T_{Dispi}$ zusammen. Die Datenerfassungszeit $T_{Mesi\_j}$ im jeweiligen Frequenzband ist wiederum proportional zu Frequenzauflösung des jeweiligen Frequenzbandes. Die Gesamtmeßzeit $T_{MGes}$ ergibt sich folglich gemäß Gleichung (1a).

$$T_{MGes} = \sum_{i=1}^{M} T_{Mi} = \sum_{i=1}^{M}\left( \sum_{j=1}^{m}\left( T_{Mesi\_j} + T_{FFTi\_j} \right) + T_{Miti} + T_{Dispi} \right) \qquad \text{(1a)}$$

Auch bei einer kompakten, entsprechend der Anzahl an Mittelungen wiederholt durchzuführenden Datenerfassung und eine anschließenden kompakten, entsprechend der Anzahl an Mittelungen wiederholt durchzuführenden Datenauswertung mittels Fourier-Analyse gemäß Fig. 1B kann keine Reduzierung der Gesamtmeßzeit $T_{MGes}$ erzielt werden. Die Gesamtmeßzeit $T_{MGes}$ ergibt sich wiederum gemäß Gl eichung (1a). Erst eine Parallelisierung der Datenerfassung und Datenauswertung mittels Fourier-Analyse führt zu einer Verringerung der Gesamtmeßzeit $T_{MGes}$ gemäß Gleichung (1b).

$$T_{MGes} = \sum_{i=1}^{M} T_{Mi} = \sum_{i=1}^{M}\left( \sum_{j=1}^{m}\left( T_{Mesi\_j} \right) + T_{FFTi} + T_{Miti} + T_{Dispi} \right) \qquad \text{(1b)}$$

Insgesamt weist ein derartiger nach der diskreten Fourier-Analyse arbeitender Spektrumanalysator mit mehreren Frequenzbändern unterschiedlicher Frequenzauflösung, der den Stand der Technik darstellt, eine vergleichsweise zu große Gesamtmeßzeit auf. Diese zu große Meßzeit ist insbesondere auf die starke sequenzielle Datenerfassung für die einzelnen Frequenzbänder über mehrere Mitteilungen zurückzuführen. Diese sequenzielle Datenerfassung für die einzelnen Frequenzbänder bedingt eine lüclcenhafte zeitliche Aufzeichnung des Signals für die einzelnen Frequenzbänder, die nachteilig eine längere Meßzeit erforderlich macht.

Der Erfindung liegt deshalb die Aufgabe zugrunde, ein Verfahren und eine Vorrichtung zur digitale Spektrumanalyse, insbesondere digitalen Fourier-Analyse, eines Signals in mehreren Frequenzbändern zu schaffen, wobei die Frequenzauflösung in den verschiedenen Bändern unterschiedlich sein kann. Das Verfahren und die Vorrichtung zur digitalen Spektrumanalyse, insbesondere Fourier-Analyse, soll einerseits eine unterbrechungsfreie Datenerfassung für jedes Frequenzband ermöglichen und andererseits die Gesamtmeßzeit der digitalen Spektrumanalyse erheblich minimieren.

Die Aufgabe der Erfindung wird durch ein Verfahren zur Spektrumanalyse eines Signals mit den Merkmalen des Anspruchs 1 und durch eine Vorrichtung zur Spektrumanalyse eines Signals mit den Merkmalen nach Anspruch 12 gelöst.

Beim erfindungsgemäßen Verfahren und bei der erfindungsgemäßen Vorrichtung zur Spektrumanalyse eines Signals wird für jedes Frequenzband zyklisch ohne Unterbrechung aus dem zu analysierenden Signal im Rahmen der Datenerfassung eine Abtastfolge mit einer für das jeweilige Frequenzband erforderlichen Abtastfrequenz generiert. Diese für jedes Frequenzband spezifische Abtastfolge wird über mehrere Abtast-Einheiten - Analog-Digital-Wandler oder Dezimierungs-Einheiten - erzeugt und in einem zum jeweiligen Frequenzband gehörigen Ringspeicher zyklisch abgespeichert. Sobald eine für die Fourier-Analyse im jeweiligen Frequenzband erforderliche Anzahl von Abtastwerten aktualisiert im jeweiligen Ringspeicher vorrätig ist, werden diese Abtastwerte ohne Unterbrechung der Datenerfassung von einem zum jeweiligen Frequenzband gehörigen FFT-Analysator ausgelesen und zur zyklischen Berechnung der aktualisierten Spektralwerte für das jeweilige Frequenzband herangezogen.

Auf diese Weise wird die Gesamtmeßzeit gemäß Gleichung (1c), die weiter unter aufgeführt ist, näherungsweise durch das Frequenzband mit dem größten Produkt aus Datenerfassungszeit und Anzahl der Mittelungen bestimmt.

Das erfindungsgemäße Verfahren und die erfindungsgemäße Vorrichtung ermöglicht als wesentlichen Vorteil gegenüber dem Stand der Technik eine beschleunigte und lückenlose online-Datenauswertung der erfaßten Daten für alle Frequenzbänder, während parallel im Hintergrund bereits die Daten für den nächsten Zyklus erfaßt werden. Während beim Stand der Technik die erfaßten Daten für alle Frequenzbänder erst nach Abschluß der gesamten FFT-Analyse dargestellt werden können, erlaubt das erfindungsgemäße Verfahren und die erfindungsgemäße Vorrichtung eine Datenanzeige bereits im Verlauf der Datenerfassung, sobald von den ersten erfaßten Daten Auswertungen vorliegen.

Um den Hard- und Software-Aufwand zur Erzeugung jeder für das jeweilige Frequenzband spezifischen Abtastfolge des zu analysierenden Signals zu minimieren, werden in einer zweiten Ausführungsform der erfindungsgemäßen Vorrichtung mehrere Abtast-Einheiten sequenziell und/oder parallel zueinander geschaltet. Während die erste Abtäst-Einheit ein reiner Analog-Digital-Wandler ist, handelt es sich bei der zweiten und allen weiteren Abtast-Einheiten um Dezimierungs-Einheiten bestehend aus einem Filter mit nachgeschalteten Unterabtastungseinheit. Durch geschickte Wahl der Teilungsfaktoren in den einzelnen Unterabtastungseinheiten der einzelnen Dezimierungs-Einheiten und durch eine geschickt gewählte Struktur der seriellen und/ oder parallelen Verschaltung der einzelnen Dezimierungs-Einheiten kann der Aufwand für die benötigten Dezimierungs-Einheiten gegenüber einer Realisierung, in der für jedes Frequenzband jeweils eine eigene Abtast-Einheit - Analog-Digital-Wandler oder Dezimierungs-Einheit - vorgesehen ist, deutlich reduziert werden.

Ein weiterer Vorteil des erfindungsgemäßen Verfahrens und der erfindungsgemäßen Vorrichtung zur Spektrumanalyse eines Signals liegt in der Nutzung der an den Rändern bzw. Überlappungsbereichen der FFT-Analysen vorliegenden Spektralwerte bzw. Leistungsdichtewerte für andere Frequenzbänder. Beispielsweise können Spektrallinien einer höherfrequenten Frequenzanalyse im Überlappungsbereich zu einer tieferfrequenten Analyse temporär zur Messung und Anzeige verwendet und durch die später eintreffende Analyse des tieferfrequenten Bandes ersetzt werden. Vorteile ergeben sich auch, falls aneinandergrenzende Bänder mit unterschiedlicher Frequenzauflösung arbeiten. Der Überlappungsbereich liegt beispielsweise mit niedriger und mit hoher Frequenzauflösung vor. Durch Nutzung der Spektralwerte mit unterschiedlicher Frequenzauflösung kann der Übergangsbereich zwischen den Frequenzbändern mit unterschiedlicher Auflösung geglättet werden.

Schließlich können für die Mittelung der aus den Spektralwerten gewonnenen Leistungsdichtewerte an den Rändern der einzelnen Frequenzbändern die von den FFT-Analysatoren der jeweils benachbarten Frequenzbänder berechneten Spektralwerte bzw. Leistungsdichtewerte an den Rändern der jeweils benachbarten Frequenzbänder gegenseitig ausgetauscht und genutzt werden. Liegen überlappende Frequenzbänder vor, so können ganz analog die Spektralwerte bzw. Leistungsdichtewerte im Überlappungsbereich des jeweils zum benachbarten Frequenzband gehörigen FFT-Analysators ebenfalls ausgetauscht und zur Mittelung genutzt werden. Auf diese Weise kann die Meßdatenauswertungszeit reduziert werden und somit früher Meßdaten angezeigt werden.

Die beiden Ausführungsformen des erfindungsgemäßen Verfahrens und erfindungsgemäßen Vorrichtung zur Spektrumanalyse eines Signals werden im folgenden unter Berücksichtigung der Zeichnung näher erläutert. In der Zeichnung zeigen:

Fig.1A, 1B     ein Zeitdiagramm einer ersten und zweiten Ausführungsform des Verfahrens und der Vorrichtung zur Spektrumanalyse eines Signals nach den Stand der Technik,

Fig. 2A, 2B     ein Blockdiagramm einer ersten und zweiten Ausführungsform der erfindungsgemäßen Vorrichtung zur Spektrumanalyse eines Signals,

Fig. 3    ein Flußdiagramm des erfindungsgemäßen Verfahrens zur Spektrumanalyse eines Signals,

Fig. 4    ein Zeitdiagramm des erfindungsgemäßen Verfahrens und der erfindungsgemäßen Vorrichtung zur Spektrumanalyse eines Signals und

Fig. 5    ein Frequenzspektrum des erfindungsgemäßen Verfahrens und der erfindungsgemäßen Vorrichtung zur Spektrumanalyse eines Signals mit vier überlappenden FFT-Frequenzbändern.

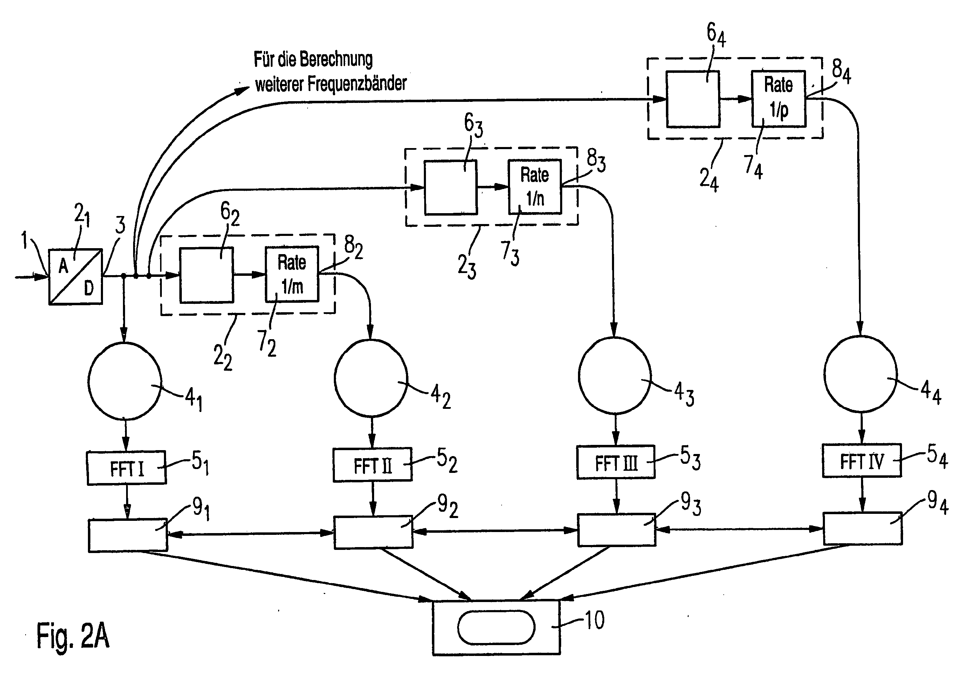

Die in Fig. 2A dargestellte erste Ausführungsform der erfindungsgemäßen Vorrichtung zur Spektrumanalyse eines Nutz- oder Rauschsignals wird am Eingang 1 der ersten Abtast-Einheit $2_1$, die als Analog-Digital-Wandler ausgeführt ist, mit dem zu analysierenden Nutz- oder Rauschsignal beaufschlagt. In der ersten Abtast-Einheit $2_1$ erfolgt eine Abtastung des analogen Nutz- oder Rauschsignals mit einer bestimmten Abtastfrequenz $f_s$. Die am Ausgang 3 der erste Abtast-Einheit $2_1$ anliegende Abtastfolge des digitalisierten Nutz- oder Rauschsignals wird einem ersten Ringspeicher $4_1$ zugeführt.

Der erste Ringspeicher $4_1$, der eine bestimmte Speicherkapazität aufweist, wird zyklisch ohne Unterbrechung mit der Abtastfolge des mit der Abtastfrequenz $f_s$ abgetasteten Nutz- oder Rauschsignals beschrieben. Sobald im ersten Ringspeicher $4_1$ eine für eine nachfolgende Fourier-Analyse ausreichende Anzahl an neuen Abtastwerten des mit der Abtastfrequenz $f_s$ digitalisierten Nutz- oder Rauschsignals abgespeichert sind, liest ein erster diskreter Fourier-Transformator $5_1$ die für eine neue diskrete Fourier-Analyse erforderliche Anzahl an Abtastwerten des mit der Abtastfrequenz $f_s$ digitalisierten Nutz- oder Rauschsignals aus und berechnet daraus die diskreten Spektralwerte des Frequenzbandes I im höchsten darzustellenden Frequenzbereich.

Die für eine Darstellung in einem bestimmten Frequenzband erforderliche Abtastrate des digitalisierten Nutz- oder Rauschsignals ist nach dem Nyquist-Kriterium mindestens mit dem doppelten Wert der oberen Grenzfrequenz des Frequenzbandes auszulegen. Gleichzeitig ergibt sich bei gegebener Frequenzauflösung im Frequenzband eine zur Frequenzauflösung proportionale Meßzeit des digitalisierten Nutz- oder Rauschsignals.

Somit ergibt sich - bei gleicher FFT-Auswertelänge und ohne Berücksichtigung von Mittelungen - für ein höherfrequentes Frequenzband eine höhere Abtastfrequenz des digitalisierten Nutz- oder Rauschsignals und aufgrund der niedrigeren Frequenzauflösung eine kleinere Meßzeit als für ein tieferfrequentes Frequenzband.

Erfindungsgemäß werden für die Darstellung in den übrigen niederfrequenteren Frequenzbändern parallel Abtastfolgen des digitalisierten Nutz- oder Rauschsignals in der jeweils geeigneten Abtastfrequenz erzeugt. Hierzu sind für die beispielsweise drei niederfrequenteren Frequenzbänder II, III und IV der erfindungsgemäßen Vorrichtung zur Spektrumanalyse eines Signals in Fig. 2A jeweils eine als Dezimierungs-Einheit realisierte zweite, dritte und vierte Abtast-Einheit $2_2$, $2_3$ und $2_4$ vorgesehen, die jeweils mit dem Ausgang 3 der ersten Abtast-Einheit $2_1$ verbunden sind.

Die Dezimierungs-Einheit $2_2$, $2_3$ und $2_4$ besteht jeweils aus einer Serienschaltung eines Tiefpaßfilters $6_2$, $6_3$ und $6_4$ und einer Unterabtastungseinheit $7_2$, $7_3$ und $7_4$. Die Unterabtastungseinheiten $7_2$, $7_3$ und $7_4$ weisen jeweils einen unterschiedlichen Frequenzteilungsfaktor $1/m$, $1/n$ und $1/p$ auf, so daß am Ausgang $8_2$ der Dezimierungs-Einheit $2_2$ eine Abtastfolge des digitalisierten Nutz- oder Rauschsignals mit einer Abtastfrequenz von $f_s/m$, am Ausgang $8_3$ der Dezimierungs-Einheit $2_3$ eine Abtastfolge des digitalisierten Nutz- oder Rauschsignals mit einer Abtastfrequenz $f_s/n$ und am Ausgang $8_4$ der Dezimierungs-Einheit $2_4$ eine Abtastfolge des digitalisierten Nutz- oder Rauschsignals mit einer Abtastfrequenz von $f_s/p$ anliegt.

Diese Abtastfolgen des digitalisierten Nutz- oder Rauschsignals mit jeweils unterschiedlicher Abtastfrequenz werden jeweils einem zweiten, dritten und vierten Ringspeicher $4_2$ $4_3$ und $4_4$ zyklisch ohne Unterbrechung zugeführt. Liegen im zweiten, dritten und vierten Ringspeicher $4_2$, $4_3$ und $4_4$ eine für die Fourier-Analyse im jeweiligen Frequenzband II, III und IV ausreichende Anzahl an neu abgespeicherten Abtastwerten des digitalisierten Nutz- oder Rauschsignals vor, so liest der jeweilige zweite, dritte und vierte diskrete Fourier-Transformator $5_2$, $5_3$ und $5_4$ diese neu abgespeicherten Abtastwerte aus und berechnet aus diesen Abtastwerten die aktualisierten Spektralwerte $\underline{A}_i(f)$ des jeweiligen Frequenzbandes II, III und IV mittels einer diskreten Fourier-Analyse. Ohne Einschränkung der Allgemeinheit kann die Frequenzauflösung für jedes Teilband durch Wahl einer entsprechenden FFT-Auswertelänge gleich oder auch unterschiedlich eingestellt werden. In den an die diskreten Fouriertransformatoren $5_1$, $5_2$, $5_3$ und $5_4$ jeweils anschließenden Funktionseinheiten $9_1$, $9_2$, $9_3$ und $9_4$ werden aus den einzelnen Spektralwerten $\underline{A}_i(f)$ die jeweiligen Leistungswerte $L_i(f)$ des Leistungsspektrum gemäß Gleichung (2) und mittels Mittelung über mehrere Mittelungsintervalle die Leistungsdichtewerte $\overline{L}_i(f)$ des Leistungsdichtespektrums gemäß Gleichung (3) berechnet.

$$\underline{L}_i(f) = \left| \underline{A}_i(f) \right|^2 \qquad\qquad\qquad (2)$$

$$\overline{L_i}(f) = \frac{1}{n}\sum_{i=1}^{n} L_i(f) \qquad\qquad (3)$$

Das Leistungsdichtespektrum $\overline{L_i}(f)$ für alle beispielsweise vier Frequenzbänder wird anschließend in einer Anzeigeeinrichtung 10 visualisiert.

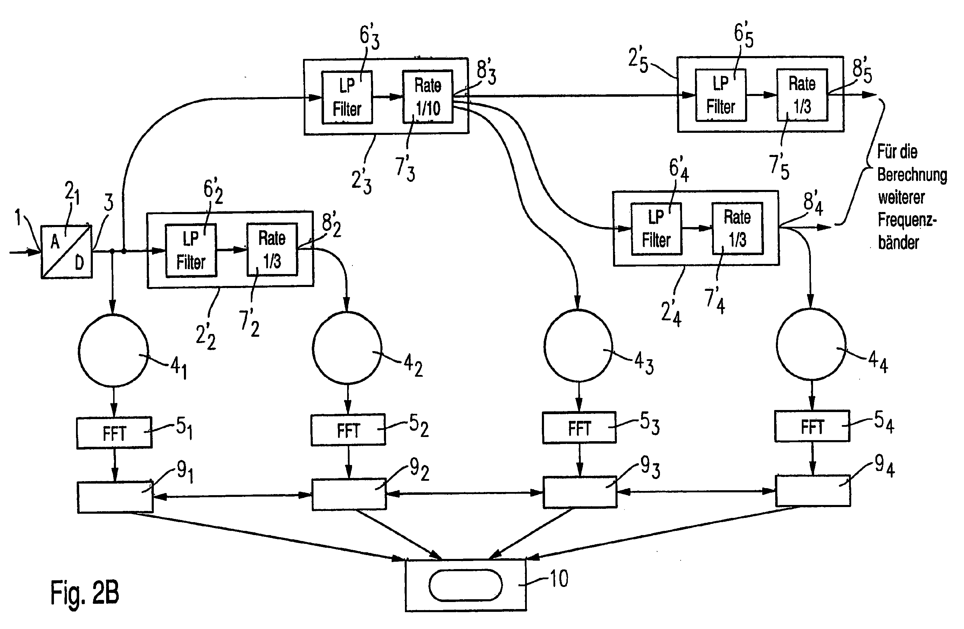

In Fig. 2B ist eine zweite Ausführungsform der erfindungsgemäßen Vorrichtung zur Spektrumanalyse eines Signals dargestellt. Für identische Merkmale der zweiten Ausführungsform zur ersten Ausführungsform werden die gleichen Bezugszeichen verwendet und auf eine wiederholte Beschreibung dieser Merkmale verzichtet.

Im Gegensatz zur ersten Ausführungsform mit einer rein parallelen Verschaltung der Dezimierungs-Einheiten $2_2$, $2_3$, $2_4$ usw. werden in der zweiten Ausführungsform die Dezimierungs-Einheiten $2_2'$, $2_3'$, $2_4'$ usw. nicht nur parallel, sondern auch seriell verschaltet. Durch die serielle Verschaltung der Dezimierungs-Einheiten ist es möglich, eine Abtastfolge des digitalisierten Nutz- oder Rauschsignals mit einer bestimmten Abtastfrequenz zu generieren und dabei die Teilungsfaktoren der einzelnen Unterabtastungseinheiten - gegenüber der ersten Ausführungsform - in den einzelnen Dezimierungs-Einheiten zu verkleinern. Kleinere Teilungsfaktoren der Unterabtastungseinheiten bedingen einen geringeren Aufwand in der Hard- und Software der einzelnen Dezimierungs-Einheiten. So können das jeweils zugeordnete Tiefpaßfilter wie auch die internen Ringspeicher der jeweiligen Dezimierungsstufen deutlich kleiner ausgelegt werden.

Bei der zweiten Ausführungsform in Fig. 2B mit einer beispielsweise halbdekadischen Auslegung der einzelnen Frequenzbänder - Frequenzband I: 30kHz -100 kHz, Frequenzband II: 10 kHz -30 kHz, Frequenzband III: 3 kHz - 10 kHz, Frequenzband IV: 1 kHz - 3 kHz - wird die Abtastfolge des digitalisierten Nutz- oder Rauschsignals für das Frequenzband I beispielsweise mit einer Abtastfrequenz von 250 kHz unter Berücksichtigung der Nyquist-Bedingung von der ersten Abtast Einheit $2_1$ erzeugt. Die Abtastfolge des digitalisierten Nutz- oder Rauschsignals für das Frequenzband II wird mit einer Abtastfrequenz von 250/3 kHz von der Dezimierungs-Einheit $2_2'$ mit einem Teilungsfaktor von 1/3 durch den zugeordnete Unterabtastungseinheit $7_2'$ aus der Abtastfolge am Ausgang 3 der ersten Abtast-Einheit $2_1$ generiert. Die Abtastfolge des digitalisierten Nutz- oder Rauschsignals für das Frequenzband III wird mit einer Abtastfrequenz von 250/10 kHz von der Dezimierungs-Einheit $3_1'$ mit einem Teilungsfaktor von 1/10 durch die zugeordnete Unterabtastungseinheit $7_3'$ aus der Abtastfolge am Ausgang 3 der ersten Abtast-Einheit $2_1$ erzeugt. Schließlich wird die Abtastfolge des digitalisierten Nutz- oder Rauschsignals für das Frequenzband IV mit einer Abtastfrequenz von 250/30 kHz durch Serienschaltung der Dezimierungs-Einheit $2_4'$ mit einem Teilungsfaktor von 1/10 durch die zugeordnete Unterabtastungseinheit $7_4'$ und der Dezimierungs-Einheit $2_3'$ mit einem Teilungsfaktor von 1/3 durch die zugeordnete Unterabtastungseinheit $7_3'$ aus der Abtastfolge am Ausgang 3 der ersten Abtast-Einheit $2_1$ generiert.

Die Abtastfolge des digitalisierten Nutz- oder Rauschsignals am Ausgang $8_3'$ der Dezimierungs-Einheit $2_3'$ mit einer Abtastfrequenz von 250/10 kHz und die Abtastfolge des digitalisierten Nutz- oder Rauschsignals am Ausgang $8_4'$ der Dezimiarungs-Einheit $2_4'$ mit einer Abtastfrequenz von 250/300 kHz können weiteren Dezimierungs-Einheiten $2_i'$ - beispielsweise Dezimierungs-Einheit $2_5'$ in Fig. 2B - zugeführt werden. Auf diese Weise lassen sich Abtastfolgen mit Abtastfrequenzen realisieren, die der Multiplikation der Teilungsfaktoren der Unterabtastungseinheiten der jeweils seriell gekoppelten Dezimierungs-Einheiten mit der Abtastfrequenz der Abtastfolge am Ausgang 3 der ersten Abtast Einheit $2_1$ entsprechen.

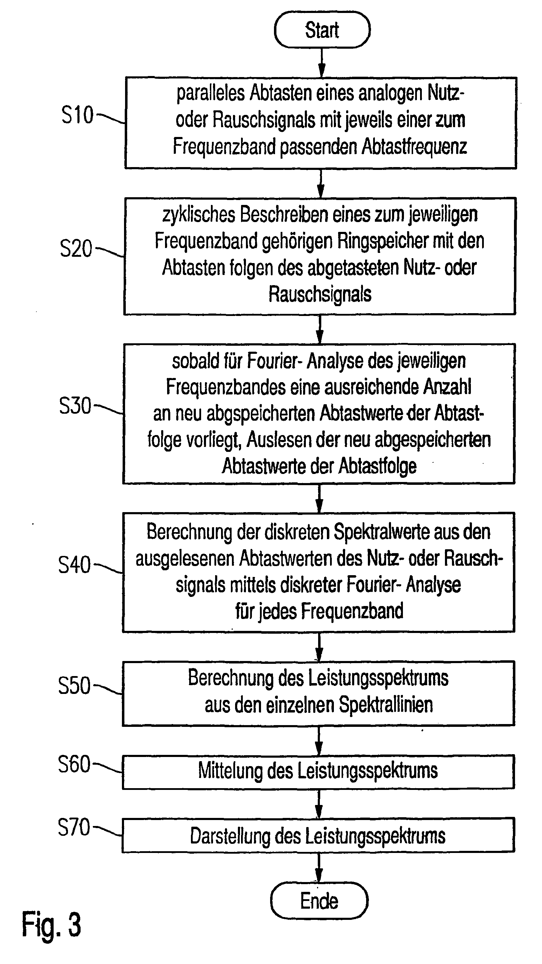

In Fig. 3 ist ein Flußdiagramm des erfindungsgemäßen Verfahrens zur Spektrumanalyse eines Nutz- oder Rauschsignals dargestellt.

In Verfahrensschritt S10 werden aus dem analogen Nutz- oder Rauschsignals für jedes Frequenzband jeweils eine Abtastfolge mit einer zum jeweiligen Frequenzband passenden Abtastfrequenz erzeugt. Die Erzeugung der Abtastfolge für jedes Frequenzband mittels Abtastung erfolgt zyklisch ohne Unterbrechung und quasi-parallel. Einzig am Beginn der Abtastung liegt auf Grund einer möglichen seriellen Ver schaltung mehrerer Abtast-Einheiten für die Abtastfolgen in niederfrequenteren Frequenzbändern eine Verzögerung $T_{Delay}$ vor.

Jede dieser Abtastfolgen mit einer für das jeweilige Frequenzband spezifischen Abtastfrequenz werden im nächsten Verfahrensschritt S20 zyklisch ohne Unterbrechung in jeweils einen Ringspeicher eingeschrieben.

Sobald im für das jeweilige Frequenzband bestimmten Ringspeicher eine für die nachfolgende Fourier-Analyse im jeweiligen Frequenzband ausreichende Anzahl an Abtastwerten der jeweiligen Abtastfolge neu abgespeichert ist, erfolgt im darauffolgenden Verfahrensschritt S30 das Auslesen dieser für die Fourier-Analyse ausreichenden Anzahl an neuen Abtastwerten der jeweiligen Abtastfolge. Auch dieses Auslesen der Abtastwerte der jeweiligen Abtastfolge erfolgt im Zyklus.

Aus den ausgelesenen Abtastwerten des mit der zum jeweiligen Frequenzband passenden Abtastfrequenz abgetasteten Nutz- oder Rauschsignals wird in Verfahrensschritt S40 in jeweils einem diskreten Fourier-Transformator je Frequenzband über eine diskrete Fourier-Analyse die zum jeweiligen Frequenzband passenden diskreten Spektralwerte berechnet.

Im nächsten Verfahrensschritt S50 erfolgt für jeden Frequenzrasterpunkt in jedem Frequenzband die Berech-

nung der einzelnen Leistungswerte $L_i$ (f) des Leistungsspektrums aus den Spektralwerten der Fourier-Analyse gemäß Gleichung (2).

In Verfahrensschritt S60 wird aus in mehreren Zyklen jeweils ermittelten Leistungswerten $L_i$ (f) des Leistungsspektrum für jeden Frequenzrasterpunkt des jeweiligen Frequenzbandes ein Leistungsdichtewerte $L_i$ (f des Leistungsdichtespektrums gemäß Gleichung (3) berechnet. Der Verfahrensschritt S60 zur Mittelung der Leistungswerte $L_i$ (f) bei jedem Frequenzrasterpunkt in jedem Frequenzband kann insbesondere auch zur Mittelung über die Frequenzbandgrenze hinaus genutzt werden.

Durch Parallelisierung der Verarbeitung wird die Datenannahmezeit zur Meßauswertung bereits aufgenommener Meßdaten genutzt.

Im abschließenden Verfahrensschritt S80 werden die einzelnen mittels Fourier-Analyse und Leistungsberechnung und -mittelung berechneten Leistungsdichtewerte $\overline{L}_i(f)$ jedes Frequenzbandes in einer Anzeigeeinrichtung 10 dargestellt. Die Meßausweztung für die verschiedenen Frequenzbänder werden im allgemeinen für die Darstellung in einem Diagramm zusammengefaßt. Wie bereits geschildert können in den Randbereichen der einzelnen Frequenzbänder Sonderbehandlungen vorgenommen werden, um die Meßkurve durch Nutzung der höheren Frequenzauflösung des jeweils tieferfrequenten Bandes zu glätten. Es ist jedoch auch möglich, nur einzelne Teilbänder in eigenen Meßfenstern zu visualisieren.

Neben der beschriebenen Mi ttelung de Frequenzbänder und der Überlappungsbereiche nach dem sogenannten Welch-Verfahren (Gl. (3)) können auch andere Mittelungsverfahren, wie z.B. eine gleitende Mittelung gemäß der Beziehung in Glg. (4) Anwendung finden.

$$\overline{L}_i(n,f) = a \cdot L_i(f) + (a-1) \cdot L_i(n-1,f) \qquad \text{mit } 0 \leq a \leq 1 \qquad (4)$$

Auch die parallele und sukzessive Anwendung mehrerer gleichartiger oder unterschiedlicher Mittelungsverfahren ist vorteilhaft möglich. So kann beispielsweise auf eine Serie bereits gemittelter Meßergebnisse eine weitere Mittelung angewendet werden, um die Meßergebnisse weiter zu glätten. Durch die parallele Anwendung von verschiedenen Mittelungsverfahren und Darstellung der gemittelten Meßergebnisse beider Verfahren können vorteilhaft Rückschlüsse auf die Zeitvarianz der Meßergebnisse vorgenommen werden.

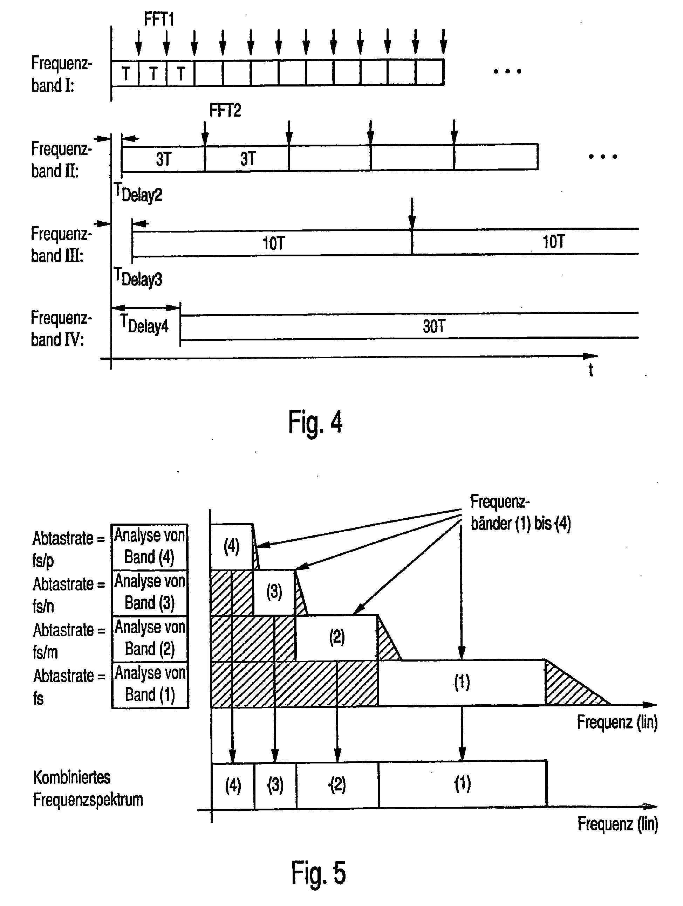

In Fig. 4 sind in einem Zeitdiagramm beispielhaft für die vier Frequenzbänder der beiden Ausführungsformen in Fig. 2A und 2B die Zeitverteilung für die Datenerfassung und Datenauswertung in jedem Frequenzband dargestellt. Aus Fig. 4 ist ersichtlich, wie obig schon mehrmals beschrieben ist, daß die Datenerfassung und -auswertung jedes Frequenzband zyklisch ohne Unterbrechung erfolgt. Bei gleicher Anzahl von Spektrallinien in jedem der vier Frequenzbänder ergibt sich für jedes Frequenzband eine Frequenzauflösung und Meßzeit, die indirekt proportional zur Startfrequenz des jeweiligen Frequenzbandes ist. Für das hochfrequente Frequenzband I ergibt sich also im Vergleich zum niederfrequenten Frequenzband IV eine deutlich kleinere Meßzeit (Meßzeit in Frequenzband I : 1*T; Meßzeit in Frequenzband IV: 30*T). Die Datenauswer tungen können in den betreffenden Recheneinheiten im Hintergrund quasi parallel stattfinden, ohne daß die Datenannahme und Dezimierung der Daten in den entsprechenden Verarbeitungsstufen davon berührt ist. Insbesondere kann im Hintergrund und quasi parallel für höherfrequente Bänder bereits Mittelungsoperationen vorgenommen werden, während die Datenannahme und -verarbeitung für tieferfrequente Bänder noch nicht abgeschlossen ist. Einzig in den niederfrequenteren Frequenzbändern II, III und IV kommt es zu Beginn der Datenerfassung und Datenauswertung aufgrund von Verzögerungszeiten in den seriell geschalteten Dezimierungs-Einheiten zu jeweils unterschiedlich großen Verzögerungszeiten $T_{Delayi}$ im jeweiligen Frequenzband i.

Durch die erfindungsgemäße Parallelisierung der Datenerfassung und -auswertung in einzelnen Frequenzbändern ergibt sich die Gesamtmeßzeit $T_{MGes}$ näherungsweise gemäß Gleichung (1c).

$$T_{MGes} \approx T_{MMAX} = \max\{T_{Mi}\}$$

mit

$$T_{Mi} = \sum_{j=1}^{m}\left(T_{Mesi\_j}\right) + T_{Delayi} + T_{FFTi} + T_{Miti} + T_{Dispi}$$

$$= m \bullet T_{Mesi} + T_{Delayi} + T_{FFTi} + T_{Miti} + T_{Dispi} \qquad (1c)$$

Die Gesamtmeßzeit $T_{MGes}$ des erfindungsgemäßen Verfahrens und der erfindungsgemäßen Vorrichtung nach Gleichung (1c) ergibt sich im wesentlichen aus dem Frequenzband mit der größten Einzelmeßzeit. Diese wird wiederum vorwiegend aus dem Produkt der Datenerfassungszeit für eine einzelne Meßauswertung und der Anzahl der Mittelungen für dieses Frequenzband bestimmt. Die weiteren additiven Terme sind dadurch verursacht, daß die entsprechenden Operationen nicht mehr parallel zur Datenannahme durchführbar sind, sondern erst sequentiell nach Fertigstellung der vorangehenden Operationen. Beispielsweise können bei m Mittelungen (m-1) FFTs parallel zur Datenannahme durchgeführt werden, die letzte FFT aber erst, wenn die entsprechende Datenannahme für die letzte FFT bereits abgeschlossen ist. Damit ergibt sich eine deutliche Reduzierung gegenüber der Gesamtmeßzeit $T_{MGes}$ des Verfahrens und der Vorrichtung des Stand der Technik mit einer Gesamtmeßzeit $T_{MGes}$' die sich nach Gleichung (1a) oder (1b) aus der Summe der Einzelmeßzeiten $T_{Mi}$ ergibt.

In Fig. 5 ist das aus vier überlappenden Frequenzbändern (1) bis (4) kombinierte Frequenzspektrum dargestellt. Aufgrund der Überlappung - schraffierte Flächen in Fig. 5 - können für tieferfrequente Frequenzbänder die für die jeweils höherfrequenten Frequenzbänder bereits erfaßten Spektralwerte für die Datenauswertung herangezogen werden. Somit reduziert sich durch Anwendung der sukzessiven Filterung, Dezimation unf Fourier-Analyse im erfindungsgemäßen Verfahren und in der erfindungsgemäßen Vorrichtung zur Spektrumanalyse eines Signals die erforderliche Meßzeit.

Die Erfindung ist nicht auf die dargestellte Ausführungsformen beschränkt. Insbesondere ist auch ein Verfahren und eine Vorrichtung von der Erfindung abgedeckt, bei der im Gegensatz zur obigen Darstellung die Messung in Richtung von tieferen Frequenzen zu hohen Frequenzen erfolgt. Auch ist von der Erfindung anstelle einer online-Datenauswertung eine offline-Datenauswertung der erfaßten, digital gewandelten und abgespeicherten Daten abgedeckt.

## Patentansprüche

1. Verfahren zur Spektrumanalyse eines Signals in mehreren überlappenden Frequenzbändern mit jeweils unterschiedlicher Frequenzauflösung, das zumindest einen Datenerfassungsschritt (S10,S20) und einen nachfolgenden Datenauswertungsschritt (S40) je Frequenzband umfasst, **dadurch gekennzeichnet,**
   **dass** sowohl der Datenerfassungsschritt (S10,S20) als auch der nachfolgende Datenauswertungsschritt (S40) für sich und für jedes Frequenzband der Spektrumanalyse jeweils zyklisch ohne Unterbrechung abläuft, wobei der Datenauswertungsschritt (S40) eine diskrete Fourier-Analyse zur Berechnung der zum jeweiligen Frequenzband gehörigen Spektralwerte des Signals beinhaltet,
   **dass** der Datenerfassungsschritt (S10,S20) eine Abtastung (S10) des Signals in einer Abtastfrequenz, die mindestens einem doppelten Wert einer oberen Grenzfrequenz des jeweiligen Frequenzbands entspricht, und eine Abspeicherung (S20) der jeweils abgetasteten Werte des Signals in einem zum jeweiligen Frequenzband gehörigen Ringspeicher ($4_1$, $4_2$, $4_3$, $4_4$, $4_1$', $4_2$', $4_3$', $4_4$') beinhaltet, und dass die bereits in einer Fourier-Analyse berechneten Spektralwerte eines höherfrequenten Frequenzbandes für niederfrequente Frequenzbänder als temporäre Spektralwerte genutzt werden, bis in den tieferfrequenten Frequenzbändern alle Spektralwerte mittels Fourier-Analyse berechnet sind.

2. Verfahren zur Spektrumanalyse nach Anspruch 1, **dadurch gekennzeichnet,**
   **dass** das Signal ein Nutzsignal, ein Rauschsignal, ein Nutzsignal mit überlagertem Rauschsignal oder / und ein überlagerten Störsignalen, oder ein Rauschsignal mit überlagerten Nutz- oder / und Störsignalen ist.

3. Verfahren zur Spektrumanalyse nach Anspruch 1 oder 2,
   **dadurch gekennzeichnet,**
   **dass** der Datenauswertungsschritt (S40) ein digitales spektrales Schätzverfahren beinhaltet.

4. Verfahren zur Spektrumanalyse nach Anspruch 3,
   **dadurch gekennzeichnet,**
   **dass** das digitale spektrale Schätzverfahren eine Fourier-Analyse ist.

5. Verfahren zur Spektrumanalyse nach einem der Ansprüche 1 bis 4,
   **dadurch gekennzeichnet,**
   **dass** die Abtastung (S10) des Signals für jedes Frequenzband sukzessive über mindestens eine untergeordnete Abtastung erfolgt.

6. Verfahren zur Spektrumanalyse nach Anspruch 5,
   **dadurch gekennzeichnet,**
   **dass** die erste untergeordnete Abtastung eine Analog-Digital-Wandlung ist.

**7.** Verfahren zur Spektrumanalyse nach Anspruch 5 oder 6,
**dadurch gekennzeichnet,**
**dass** die zweite und alle folgenden untergeordneten Abtastungen jeweils aus einer Filterung und einer nachfolgenden Unterabtastung bestehen.

**8.** Verfahren zur Spektrumanalyse nach einem der Ansprüche 1 bis 7,
**dadurch gekennzeichnet,**
**dass** die einzelnen Frequenzbänder sich ganz oder teilweise überlappen.

**9.** Verfahren zur Spektrumanalyse nach Anspruch 8,
**dadurch gekennzeichnet,**
**dass** für mindestens ein Frequenzband im Anschluss an oder während mehrerer zyklisch durchlaufenen Datenerfassungsschritten (S10,S20) und Datenauswertungsschritten (S40) mindestens ein Mittelungsschritt (S50) der in den einzelnen Datenauswertungsschritten (S40) jeweils berechneten Spektralwerte erfolgt.

**10.** Verfahren zur Spektrumanalyse nach Anspruch 9,
**dadurch gekennzeichnet,**
**dass** für die Mittelung (S50) der Spektralwerte am Rand des jeweiligen Frequenzbandes die Spektralwerte am Rand des jeweiligen Frequenzbandes und/oder Spektralwerte im Überlappungsbereich des sich mit dem jeweiligen Frequenzband überlappenden weiteren Frequenzbandes berücksichtigt werden.

**11.** Verfahren zur Spektrumanalyse nach Anspruch 9 oder 10,
**dadurch gekennzeichnet,**
**dass** nach der Fourier-Analyse (S40) und Mittelung (50) der Spektralwerte jedes Frequenzbandes die Darstellung (S60) der Spektralwerte erfolgt.

**12.** Vorrichtung zur Spektrumanalyse eines Signals in mehreren überlappenden Frequenzbändern mit jeweils unterschiedlicher Frequenzauflösung
mit mehreren Abtast-Einheiten ($2_1$, $2_2$, $2_3$, $2_4$; $2_2'$, $2_3'$, $2_4'$), wobei die mehreren Abtast-Einheiten ($2_1$, $2_2$, $2_3$, $2_4$; $2_2'$,$2_3'$,$2_4'$) eingerichtet sind, die jeweils zum jeweiligen Frequenzband gehörigen Abtastfolgen mit einer mindestens einem doppelten Wert einer oberen Grenzfrequenz des jeweiligen Frequenzbands entsprechenden Abtastfrequenz zu erzeugen,
mit zugehörigen Ringspeichern ($4_1$, $4_2$, $4_3$, $4_4$, $4_1'$, $4_2'$, $4_3'$, $4_4'$), wobei die Ringspeicher ($4_1$, $4_2$, $43$, $4_4$, $4_1'$, $4_2'$, $4_3'$, $4_4'$) eingerichtet sind, für jeweils ein Frequenzband eine Abtastfolge des Signals zyklisch ohne Unterbrechung abzuspeichern,
und mit zugehörigen diskreten Fourier-Transformatoren ($5_1$, $5_2$, $5_3$, $5_4$, $5_1'$, $5_2'$, $5_3'$, $5_4'$), wobei die diskreten Fourier-Transformatoren ($5_1$, $5_2$, $5_3$, $5_4$, $5_1'$, $5_2'$, $5_3'$, $5_4'$) eingerichtet sind, die jeweils zum jeweiligen Frequenzband gehörigen Spektralwerte zyklisch ohne Unterbrechung zu berechnen, wobei bis zur Berechnung aller Spektralwerte in den tieferfrequenten Frequenzbändern eine Nutzung der bereits in einer Fourier-Analyse berechneten Spektralwerte eines höherfrequenten Frequenzbandes für niederfrequente Frequenzbänder als temporäre Spektralwerte erfolgt.

**13.** Vorrichtung zur Spektrumanalyse nach Anspruch 12,
**dadurch gekennzeichnet,**
**dass** die Abtast-Einheiten ($2_1$, $2_2'$, $2_3'$, $2_4'$) seriell und/oder parallel zueinander geschaltet sind.

**14.** Vorrichtung zur Spektrumanalyse nach Anspruch 12 oder 13,
**dadurch gekennzeichnet,**
**dass** die erste Abtast-Einheit ($2_1$) ein Analog-Digital-Wandler ist.

**15.** Vorrichtung zur Spektrumanalyse nach einem der Ansprüche 12 bis 14,
**dadurch gekennzeichnet,**
**dass** die zweite und alle weiteren Abtast-Einheiten ($2_2$, $2_3$, $2_4$, $2_2'$, $2_3'$, $2_4'$) jeweils eine Dezimierungs-Einheit ($2_2$, $2_3$, $2_4$, $2_2'$, $2_3'$, $2_4'$) bestehend aus einem Tiefpaßfilter ($6_2$, $6_3$, $6_4$, $6_2'$, $6_3'$, $6_4'$) und einer nachfolgenden Unterabtastungseinheit ($7_2$, $7_3$, $7_4$, $7_2'$, $7_3'$, $7_4'$) ist.

**16.** Vorrichtung zur Spektrumanalyse nach einem der Ansprüche 12 bis 15,
**dadurch gekennzeichnet,**
**dass** jedem diskreten Fouriertransformator ($5_1$,$5_2$,$5_3$,$5_4$) jeweils eine Funktionseinheit zur Leistungs- und Leistungs-

dichte-Berechnung ($9_1$, $9_2$, $9_3$, $9_4$) nachgeschaltet ist, welche wiederum mit einer Anzeigeeinrichtung (10) verbunden sind.

**Claims**

1. Method for spectral analysis of a signal in a plurality of overlapping frequency bands each with a different frequency resolution, which comprises at least one data acquisition step (S10, S20) and a following data evaluation step (S40) for each frequency band,
   **characterised in that** both the data acquisition step (S10, S20) and the following data evaluation step (S40) per se and for each frequency band of the spectrum analysis in each case take place cyclically without interruption, wherein the data evaluation step (S40) includes a discrete Fourier analysis to calculate the spectral values of the signal belonging to the respective frequency band,
   **in that** the data acquisition step (S10 ,S20) includes sampling (S10) of the signal with a sampling frequency which corresponds to at least double the value of an upper limit frequency of the respective frequency band, and storing (S20) of the respective sampled values of the signal in a ring memory ($4_1$, $4_2$, $4_3$, $4_4$, $4_1'$, $4_2'$, $4_3'$ $4_4'$) belonging to the respective frequency band, and
   **in that** the spectral values of a higher-frequency frequency band already calculated in a Fourier analysis are used for lower-frequency frequency bands as temporary spectral values until all the spectral values in the lower-frequency frequency bands have been calculated by means of Fourier analysis.

2. Method for spectral analysis according to claim 1,
   **characterised in that** the signal is a useful signal, a noise signal, a useful signal with an overlaid noise signal or/and overlaid interference signals, or a noise signal with overlaid useful or/and interference signals.

3. Method for spectral analysis according to claim 1 or 2,
   **characterised in that** the data evaluation step (S40) includes a digital spectral estimating process.

4. Method for spectral analysis according to claim 3,
   **characterised in that** the digital spectral estimating process is a Fourier analysis.

5. Method for spectral analysis according to one of claims 1 to 4,
   **characterised in that** the sampling (S10) of the signal for each frequency band is carried out successively by means of at least one subordinate sampling operation.

6. Method for spectral analysis according to claim 5,
   **characterised in that** the first subordinate sampling operation is an analogue-digital conversion.

7. Method for spectral analysis according to claim 5 or 6,
   **characterised in that** the second and all the following subordinate sampling operations consist in each case of a filtering and a following sub-sampling operation.

8. Method for spectral analysis according to one of claims 1 to 7,
   **characterised in that** the individual frequency bands wholly or partially overlap.

9. Method for spectral analysis according to claim 8,
   **characterised in that** for at least one frequency band following or during a plurality of cyclically running data acquisition steps (S10, S20) and data evaluation steps (S40) at least one averaging step (S50) is carried out on the spectral values calculated in the individual data evaluation steps (S40).

10. Method for spectral analysis according to claim 9,
    **characterised in that** for the averaging (S50) of the spectral values at the edge of the respective frequency band account is taken of the spectral values at the edge of the respective frequency band and/or spectral values in the overlapping region of the further frequency band overlapping with the respective frequency band.

11. Method for spectral analysis according to claim 9 or 10,
    **characterised in that** after the Fourier analysis (S40) and averaging (S50) of the spectral values of each frequency band the spectral values are displayed (S60).

**12.** Device for spectral analysis of a signal in a plurality of overlapping frequency bands each with a different frequency resolution,
with a plurality of sampling units ($2_1$, $2_2$, $2_3$, $2_4$; $2_2$', $2_3$', $2_4$'), wherein the plurality of sampling units ($2_1$, $2_2$, $2_3$, $2_4$; $2_2$', $2_3$', $2_4$') are configured to produce the sampling sequences belonging to the respective frequency band in each case with a sampling frequency corresponding to at least double the value of an upper limit frequency of the respective frequency band,
with associated ring memories ($4_1$, $4_2$, $4_3$, $4_4$, $4_1$', $4_2$', $4_3$', $4_4$'), wherein the ring memories ($4_1$, $4_2$, $4_3$, $4_4$, $4_1$', $4_2$', $4_3$', $4_4$') are configured to store a sampling sequence of the signal cyclically without interruption for one frequency band in each case, and with associated discrete Fourier transformers ($5_1$, $5_2$, $5_3$, $5_4$, $5_1$', $5_2$', $5_3$', $5_4$'), wherein the discrete Fourier transformers ($5_1$, $5_2$, $5_3$, $5_4$, $5_1$', $5_2$', $5_3$', $5_4$') are configured to calculate the spectral values belonging to the respective frequency band cyclically without interruption in each case, wherein use is made of the spectral values of a higher-frequency frequency band already calculated in a Fourier analysis as temporary spectral values for lower-frequency frequency bands until all the spectral values in the lower-frequency frequency bands have been calculated.

**13.** Device for spectral analysis according to claim 12,
**characterised in that** the sampling units ($2_1$, $2_2$', $2_3$', $2_4$') are connected to one another in series and/or in parallel.

**14.** Device for spectral analysis according to claim 12 or 13,
**characterised in that** the first sampling unit ($2_1$) is an analogue-digital converter.

**15.** Device for spectral analysis according to one of claims 12 to 14,
**characterised in that** the second and all the further sampling units ($2_2$, $2_3$, $2_4$, $2_2$', $2_3$', $2_4$') are in each case a decimating unit ($2_2$, $2_3$, $2_4$, $2_2$', $2_3$', $2_4$') consisting of a lowpass filter ($6_2$, $6_3$, $6_4$, $6_2$', $6_3$', $6_4$') and a following subsampling unit ($7_2$, $7_3$, $7_4$, $7_2$', $7_3$', $7_4$').

**16.** Device for spectral analysis according to one of claims 12 to 15,
**characterised in that** each discrete Fourier transformer ($5_1$, $5_2$, $5_3$, $5_4$) is followed in each case by a function unit ($9_1$, $9_2$, $9_3$, $9_4$) for calculating power and power density which again is connected in each case with a display device (10).

**Revendications**

**1.** Procédé d'analyse spectrale d'un signal dans plusieurs bandes de fréquences se chevauchant avec chacune une résolution de fréquence différente, ledit procédé comprenant au moins une étape de saisie de données (S10, S20) et une étape d'analyse de données (S40) consécutive par bande de fréquences,
**caractérisé en ce que**
l'étape de saisie de données (S10, S20) ainsi que l'étape d'analyse de données (S40) consécutive sont exécutées chacune cycliquement sans interruption en soi et pour chaque bande de fréquences de l'analyse spectrale, l'étape d'analyse de données (S40) comprenant une analyse de Fourier discrète pour le calcul des valeurs spectrales du signal relevant de la bande de fréquences respective,
**en ce que** l'étape de saisie de données (S10, S20) comprend un balayage (S10) du signal dans une fréquence de balayage correspondant au moins au double de la valeur d'une fréquence limite supérieure de la bande de fréquences respective, et une mémorisation (S20) des valeurs respectivement balayées du signal dans une mémoire circulaire ($4_1$, $4_2$, $4_3$, $4_4$, $4_1$-, $4_2$-, $4_3$-, $4_4$-) relevant de la bande de fréquences correspondante, et **en ce que** les valeurs spectrales d'une bande de hautes fréquences déjà calculées lors d'une analyse de Fourier sont utilisées comme valeurs spectrales temporaires pour des bandes de basses fréquences, jusqu'à ce que toutes les valeurs spectrales soient calculées par analyse de Fourier dans les bandes de basses fréquences.

**2.** Procédé d'analyse spectrale selon la revendication 1,
**caractérisé en ce que**
le signal est un signal utile, un signal de bruit, un signal utile à signal de bruit superposé et/ou un signal parasite superposé, ou un signal de bruit à signaux utiles et/ou signaux parasites superposés.

**3.** Procédé d'analyse spectrale selon la revendication 1 ou 2,
**caractérisé en ce que**
l'étape d'analyse de données (S40) comprend un procédé d'évaluation spectrale numérique.

**4.** Procédé d'analyse spectrale selon la revendication 3, **caractérisé en ce que**
le procédé d'évaluation spectrale numérique est une analyse de Fourier.

**5.** Procédé d'analyse spectrale selon l'une des revendications 1 à 4,
**caractérisé en ce que**
le balayage (S10) du signal pour chaque bande de fréquences est effectué de manière successive avec au moins un balayage secondaire.

**6.** Procédé d'analyse spectrale selon la revendication 5,
**caractérisé en ce que**
le premier balayage secondaire est une conversion analogique-numérique.

**7.** Procédé d'analyse spectrale selon la revendication 5 ou 6,
**caractérisé en ce que**
le deuxième, ainsi que tous les autres balayages secondaires suivants consistent chacun en un filtrage et un sous-balayage consécutif.

**8.** Procédé d'analyse spectrale selon l'une des revendications 1 à 7,
**caractérisé en ce que**
les différentes bandes de fréquences se chevauchent en totalité ou en partie.

**9.** Procédé d'analyse spectrale selon la revendication 8,
**caractérisé en ce que**
pour au moins une bande de fréquences consécutive à plusieurs étapes de saisie de données (S10, S20) et étapes d'analyse de données (S40) à exécution cyclique, ou pendant celles-ci, est effectuée au moins une étape de formation de moyenne (S50) des valeurs spectrales calculées dans les différentes étapes d'analyse de données (S40).

**10.** Procédé d'analyse spectrale selon la revendication 9,
**caractérisé en ce que**
pour la formation de moyenne (S50) des valeurs spectrales au bord d'une bande de fréquences, les valeurs spectrales au bord de la bande de fréquences et/ou les valeurs spectrales dans la zone de chevauchement de l'autre bande de fréquences avec la bande de fréquences sont prises en compte.

**11.** Procédé d'analyse spectrale selon la revendication 9 ou 10,
**caractérisé en ce que**
la représentation (S60) des valeurs spectrales est effectuée après l'analyse de Fourier (S40) et la formation de moyenne (50) des valeurs spectrales de chaque bande de fréquences.

**12.** Dispositif d'analyse spectrale d'un signal dans plusieurs bandes de fréquences se chevauchant avec chacune une résolution de fréquence différente,
avec plusieurs unités de balayage ($2_1$, $2_2$, $2_3$, $2_4$ ; $2_2$-, $2_3$-, $2_4$-),
lesdites plusieurs unités de balayage ($2_1$, $2_2$, $2_3$, $2_4$ ; $2_2$-, $2_3$-, $2_4$-) étant prévues chacune pour générer les séquences de balayage relevant de la bande de fréquences respective avec une valeur correspondant au moins au double de la valeur d'une fréquence limite supérieure de la bande de fréquences,
avec des mémoires circulaires ($4_1$, $4_2$, $4_3$, $4_4$, $4_1$-, $4_2$-, $4_3$-, $4_4$-) correspondantes, lesdites mémoires circulaires ($4_1$, $4_2$, $4_3$, $4_4$, $4_1$-, $4_2$-, $4_3$-, $4_4$-) étant prévues pour mémoriser chacune une bande de fréquences d'une séquence de balayage du signal cycliquement sans interruption,
et avec des transformateurs de Fourier ($5_1$, $5_2$, $5_3$, $5_4$, $5_1$-, $5_2$-, $5_3$-, $5_4$-) discrets correspondants, lesdits transformateurs de Fourier ($5_1$, $5_2$, $5_3$, $5_4$, $5_1$-, $5_2$-, $5_3$-, $5_4$-) discrets étant prévus pour calculer les valeurs spectrales relevant de la bande de fréquences respective cycliquement sans interruption, les valeurs spectrales d'une bande de hautes fréquences déjà calculées lors d'une analyse de Fourier étant utilisées comme valeurs spectrales temporaires pour des bandes de basses fréquences, jusqu'à ce que toutes les valeurs spectrales soient calculées dans les bandes de basses fréquences.

**13.** Dispositif d'analyse spectrale selon la revendication 12,
**caractérisé en ce que**
les unités de balayage ($2_1$, $2_2$-, $2_3$-, $2_4$-) sont montées en série et/ou en parallèle.

**14.** Dispositif d'analyse spectrale selon la revendication 12 ou 13,
**caractérisé en ce que**
la première unité de balayage ($2_1$) est un convertisseur analogique-numérique.

**15.** Dispositif d'analyse spectrale selon l'une des revendications 12 à 14,
**caractérisé en ce que**
la deuxième, et toutes les autres unités de balayage ($2_2$, $2_3$, $2_4$, $2_2$-, $2_3$-, $2_4$-) sont chacune une unité de décimation ($2_2$, $2_3$, $2_4$, $2_2$-, $2_3$-, $2_4$-) composée d'un filtre passe-bas ($6_2$, $6_3$, $6_4$, $6_2$-, $6_3$-, $6_4$-) et d'une unité de sous-balayage ($7_2$, $7_3$, $7_4$, $7_2$-, $7_3$-, $7_4$-).

**16.** Dispositif d'analyse spectrale selon l'une des revendications 12 à 15,
**caractérisé en ce que**
chaque transformateur de Fourier ($5_1$, $5_2$, $5_3$, $5_4$) discret est suivi d'une unité fonctionnelle pour le calcul de puissance et de densité de puissance ($9_1$, $9_2$, $9_3$, $9_4$), laquelle est elle-même reliée à un dispositif d'affichage (10).

Fig. 1A    (Stand der Technik)

Fig. 1B    (Stand der Technik)

Fig. 2A

Für die Berechnung weiterer Frequenzbänder

Fig. 2B

Start

S10 — parallels Abtasten eines analogen Nutz- oder Rauschsignals mit jeweils einer zum Frequenzband passenden Abtastfrequenz

S20 — zyklisches Beschreiben eines zum jeweiligen Frequenzband gehörigen Ringspeicher mit den Abtasten folgen des abgetasteten Nutz- oder Rauschsignals

S30 — sobald für Fourier- Analyse des jeweiligen Frequenzbandes eine ausreichende Anzahl an neu abgspeicherten Abtastwerte der Abtast- folge vorliegt, Auslesen der neu abgespeicherten Abtastwerte der Abtastfolge

S40 — Berechnung der diskreten Spektralwerte aus den ausgelesenen Abtastwerten des Nutz- oder Rausch- signals mittels diskreter Fourier- Analyse für jedes Frequenzband

S50 — Berechnung des Leistungsspektrums aus den einzelnen Spektrallinien

S60 — Mittelung des Leistungsspektrums

S70 — Darstellung des Leistungsspektrums

Ende

## Fig. 3

FFT1

Frequenzband I:

| T | T | T |   |   |   |   |   |   |   |   |   |

· · ·

FFT2

Frequenzband II:

| 3T | 3T |   |   |   |

$T_{Delay2}$

· · ·

Frequenzband III:

| 10T | 10T |

$T_{Delay3}$

Frequenzband IV:

$T_{Delay4}$

| 30T |

t

**Fig. 4**

Abtastrate =
fs/p

Analyse von
Band (4)

Abtastrate =
fs/n

Analyse von
Band (3)

Abtastrate =
fs/m

Analyse von
Band (2)

Abtastrate =
fs

Analyse von
Band (1)

Frequenzbänder (1) bis (4)

(4)

(3)

(2)

(1)

Frequenz (lin)

Kombiniertes
Frequenzspektrum

| (4) | (3) | (2) | (1) |

Frequenz (lin)

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2137172 A1
- DE 4330425 A1
- US 5748507 A1
- DE 4011577 A1